# EUROPEAN PATENT SPECIFICATION

(11) **EP 0 513 366 B1**
(45) Date of publication and mention of the grant of the patent: **18.09.1996**
(21) Application number: 91918941.5
(22) Date of filing: 31.10.1991
(51) Int. Cl.: H05K 3/34, B23K 3/00, B23K 3/047

(54) **DEVICE FOR SOLDERING**
LÖTANLAGE
DISPOSITIF DE BRASAGE

(30) Priority: 28.11.1990 JP 327421/90; 21.01.1991 JP 20512/91; 29.05.1991 JP 153979/91
(43) Date of publication of application: 19.11.1992
(73) Proprietor: NIHON ALMIT KABUSHIKI KAISHA, Tokyo 151 (JP)
(72) Inventor: KAWAGUCHI, Toranosuke Nihon Almit Co., Ltd., Shibuya-ku Tokyo 151 (JP)
(74) Representative: Casalonga, Axel
(86) International application number: JP9101487
(87) International publication number: WO9210078

(56) References cited:
- DE-A- 3 342 279
- JP-A-55 086 190
- JP-A-59 094 572
- JP-A-61 208 291
- JP-A-61 276 767
- JP-U-59 001 466
- PATENT ABSTRACTS OF JAPAN vol. 13, no. 248 (E-770)9 June 1989 & JP-A-10 48 494
- PATENT ABSTRACTS OF JAPAN vol. 11, no. 140 (M-586)8 May 1987 & JP-A-61 276 767
- IBM TECHNICAL DISCLOSURE BULLETIN vol. 30, no. 3, 30 August 1987, ARMONK, NEW YORK, USA pages 1243 - 1244 'contact solder reflow frame'
- PATENT ABSTRACTS OF JAPAN vol. 8, no. 207 (M-327)21 September 1984 & JP-A-59 094 572

## Description

This invention relates to the soldering equipment for soldering electronic parts and a printed board.

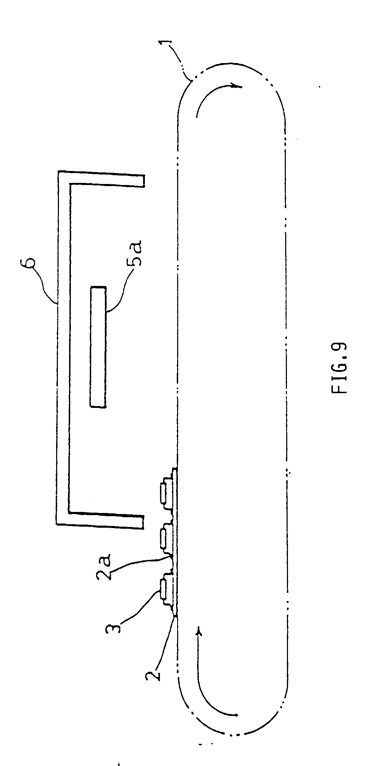

A conventional soldering equipment for soldering electronic parts and a printed board by heating them consists of a printed board 2 on which electronic parts 3 comprising LSIs for example have been loaded after soldering paste has been printed and coated in the Preceding progress of work,not illustrated, as in a reflow furnace shown in FIG.9, a belt conveyor 1 for conveying this printed board, a chamber 6 into which the printed board 2 is conveyed by the belt conveyor, a heating device 5a for melting by heating the soldering paste sticking to the printed board conveyed into the chamber, and a cooling device for cooling the printed board 2 conveyed out of the chamber 6 by the belt conveyor I which is not illustrated.

The soldering paste is a mixture composed of low melting point soldering alloy powder including Sn, Pb, Bi and so on, organic solvent, inorganic solvent, plastic, etc.

The objects of soldering are not only the electronic parts 3 but also other parts and elements.

But in the conventional soldering equipment the electronic parts 3 are put simply on the printing surface of soldering paste coated on the printed board and are soldered on the printed board by heating from above and melting the soldering paste.

Therefore it requires much soldering paste and produces soldering flux remainder.

In addition, the adhesive strength of soldering is low, and the portions which do not need heating are heated because the convectional and all-out heating method is adopted.

As a result, much heating energy is consumed, and the soldered parts are heated again, which causes the heating damage of the whole printed board. They are problems.

Particularly, the soldering flux remainder needs a washing process after the soldering process, which causes an environmental problem.

DE-A-3 342 279 discloses a pressure plate T enclosing an elastic insert E and being provided with bracket means which is pressed against a substrate having leads thereon. The elastic insert can be made e.g. of silicon rubber covered with silicon foil.

Thus the purposes of this invention are to suppress the production of the soldering flux remainder by decreasing the soldering paste quantity, to obstruct the heating damage of the whole printed board by decreasing the heating energy and to supply a simply constituted soldering equipment.

A soldering equipment according to the invention comprises a heating device which heats a printed board with soldering paste and parts on it to melt the soldering paste and further comprises a press heating device. The press heating device consists of a heat resisting sheet which is patchless or seamless, a container with a downward opening which is closed up by the heat resisting sheet, and heat resisting liquid which is put in the container closed up by the heat resisting sheet. The heating device heats the heat resisting liquid in the container closed up, the press heating device pressing and heating only the parts put on the printed board simply through the heat resisting sheet after descending from above.

In another working example of this invention the soldering equipment consists of a heating device which heats a printed board with soldering paste and parts on it to melt the soldering paste. It further comprises a press heating device, which consists of a heat resisting sheet which is patchless or seamless, a container with a downward opening which is closed up by the heat resisting sheet and heat resisting liquid which is put in the container closed up by the heat resisting sheet. The heating device heats the heat resisting liquid in the container closed up. A lifting means presses the parts against the heat resisting sheet by lifting a heating plate on which the printed board is set.

In this invention, a direct conduction heating method is adopted so that the soldering paste consumption is reduced and the production of soldering flux remainder is less.

In addition, the soldering strength is raised by pressing, heating time is shortened and required heating energy is lowered and overall heating of the printed board is avoided because only the necessary portion is heated through direct conduction.

Therefore the heat damage of the parts on the printed board is obstructed.

Although the lead of the part such as an LSI is deformed slightly, it is combined positively with the copper foil pattern by this press soldering.

The heat capacity of heat resisting liquid is big in comparison with metal and the uniformity of its temperature is kept, so it is easy to control the temperature during soldering work. On the other hand, a heat resisting sheet which is patchless or seamless is used, so the constitution of the press heating device is simple and the adaptability to the shape of the part on the printed board is easy.

As described above, in this invention, the part is pressed and heated by the press device heated by the heating device up to the temperature higher than the melting point of soldering paste, so the soldering strength is raised, and only the press device and a portion of the part are heated, so the heat damages of all parts and the printed board are obstructed. These are the effects of this invention.

In the case of parts loaded on both sides of a printed board, soldering process is simple.

An embodiment of this invention does not heat the main body Of the electronic part but only its leads, so the heat damage and the performance trouble of the electronic portion is prevented.

Furthermore, a reflow furnace can be omitted as occasion demands.

The heating efficiency of this invention is high because the conduction heating method is adopted while the radiation heating method is adopted in reflow furnace heating.

Moreover, the lead is put on the pattern surface coated with soldering paste, so soldering work is finished positively in a short time resulting from the press effect of the weight of the heat reservoir itself and the heat influence on the electronic parts is reduced.

In addition, after the conventional reflow furnace soldering process as the foregoing one in which only allowable electronic parts and the printed board are soldered, the new soldering process related to this invention as the finishing one in which only heat-frail parts and the printed board are soldered can be adopted.

Furthermore, another modified soldering process without a reflow furnace in which the parts and the printed board are soldered in the enclosed space including reducing gas produced through the decomposition of ethanol or inactive gas such as nitrogen sent in by a pipe on condition that the said enclosed space is formed between external bottom surface of the heat reservoir and the printed board surface can be adopted because it facilitates soldering work and reduces the consumption of the soldering paste which does not oxidize easily in such an environment.

Moreover, the soldering paste is heated by direct conduction.

Therefore, its consumption and the soldering flux remainder decrease. The soldering strength is raised because of press soldering. The required heating energy is reduced because of partial heating of the printed board. The heat damage of the parts on board is less because of limited heating of required portions.

Although the lead of the part is deformed slightly, it is combined positively with the copper foil pattern by this press soldering.

The heat capacity of the heat resisting liquid is larger than that of metal, so the uniformity of its temperature is kept and the temperature control of the former in operation is easier.

The use of patchless or seamless heat resisting sheet makes the constitution of the press heating device simple, and adapts to the shape of the parts on the printed board easily.

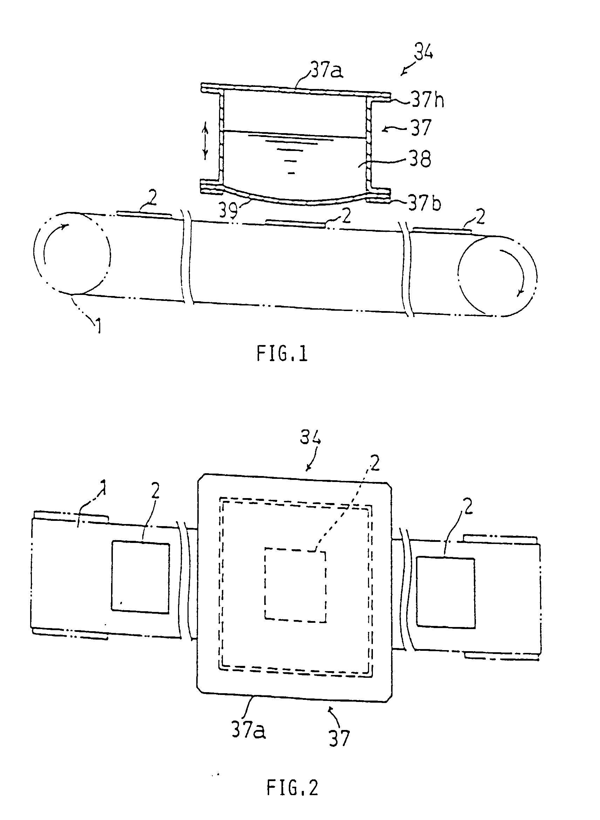

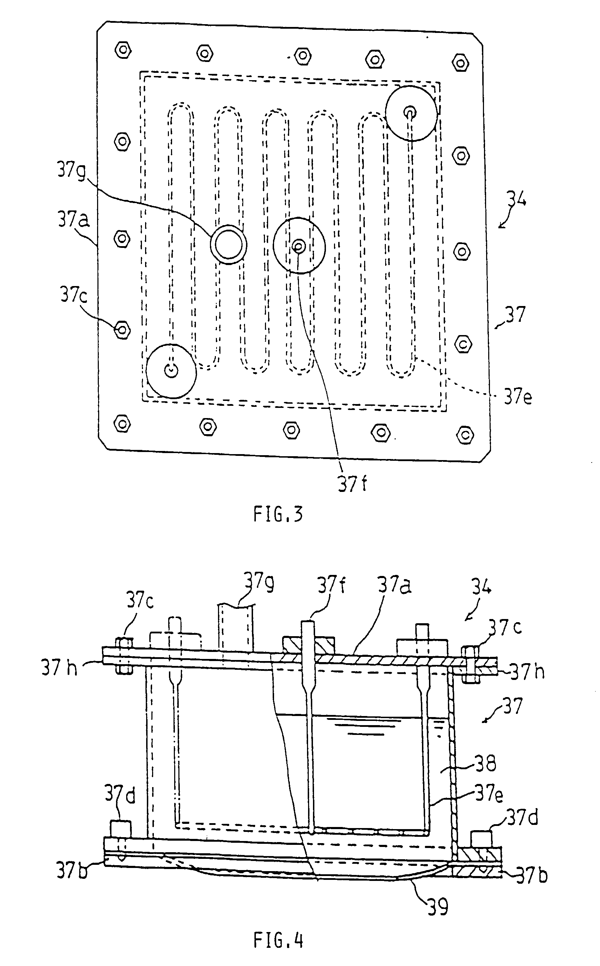

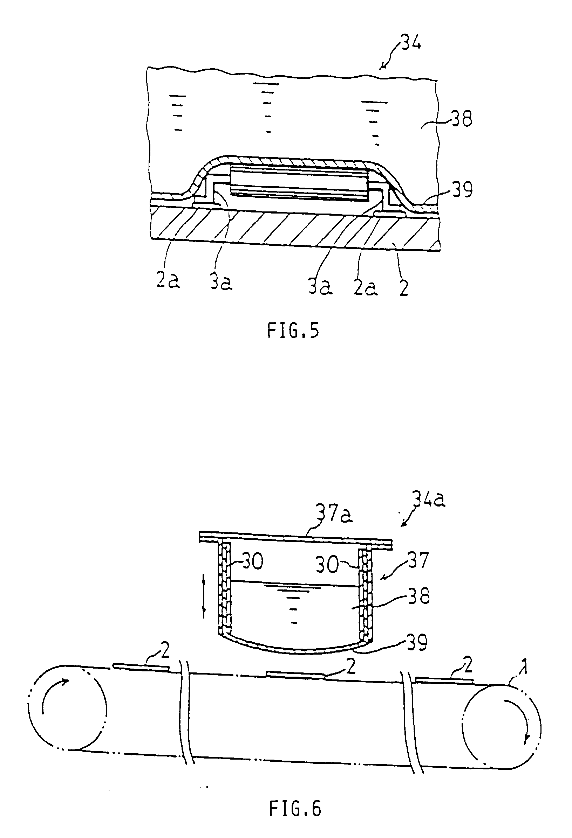

FiG. 1 shows a structure of a working example of this invention. FIG. 2 is a plan view. FIG. 3 is a partial expanded plan view. FIG. 4 and FIG. 5 show partial expanded sections. FIG. 6, FIG. 7 and FIG. 8 show the structures of further working examples of this invention. FIG. 9 shows a conventional type structure.

We explain the working examples of this invention below referring to drawings.

FIG.1 shows a constitution of a working example of this invention. FIG.2 is a plan view. FIG.3 and FIG.4 show the detailed constitution of the press heating device 34.

A conveyor 1 on which soldering paste is coated conveys printed boards 2 with parts 3 loaded on them, but this conveyor 1 is not necessarily needed here.

A press heating device 34 consists of a patchless or seamless heat resisting sheet 39, a container 37 with a downward opening which is closed up by the heat resisting sheet 39, heat resisting liquid 38 which is put in the container 37 closed up by the heat resisting sheet 39 and a heating device 37e including a nichrome wire which heats the heat resisting liquid 38 in the container 37 closed up by the heat resisting sheet 39. It presses and heats only the parts 3 conductively necessary to be heated separately by the heat resisting sheet 39 descending down from above.

Two element alloy including Sn and Pb whose melting point is low, three element alloy including Sn, Pb and Bi whose melting point is lower, heat resisting teflon oil and so on are used as the heat resisting liquid 38.

The patchless or seamless heat resisting sheet 39 is constituted by a plastic film such as polyphenylene sulfide or polyimide film and one or two metal foils such as copper foils laminated by a methanol spray on either or both sides thereof. The heat resisting sheet 39 may be only a metal foil such as a copper foil and only one sheet or plural sheets may be used.

The container 37 of the press heating device 34 includes a temperature sensor for detecting and controlling the temperature of the heat resisting liquid 38 and is enclosed by a cover 37a with a pouring inlet 37g of the heat resisting liquid 38.

The cover 37a may be connected with a flange 37h of the container 37 by bolts 37c and the heat resisting sheet 39 with an other flange 37b by bolts 37d.

The mechanism which makes the press heating device 34 descend from above such as a piston mechanism is not shown in any figure, but it makes the press heating device 34 descend from the position shown in FIG.10 1 and the printed board 2 with parts 3 loaded on it is pressed by the heat resisting sheet as shown in FIG. 5.

Thus, the portion of the lead 3a to be soldered in contact with the soldering paste coated on the copper foil pattern 2a is heated and pressed against it at the same time.

The heat resisting sheet 39 of the press heating device 34 is flexible, so it presses the parts 3 adapting its form to their ones.

In this case the required pressing force may be controlled by the adjustment of the quantity of the heat resisting liquid 38 to be used or by the mechanism descending from above such as a piston as occasion demands.

In order to prevent the parts loaded on the printed board from moving at this time, adhesive for example may be used for fixing them on it in advance. A hot wind heating device which heats the printed board by hot wind blowing from beneath may be installed, which is not shown in FIG. 5.

In order to make this easy, meshy or bored parts through which the hot wind passes may be attached to the conveyor 1.

FIG. 6 shows another working example of this invention.

The end portion of the heat resisting sheet 39 is held on the inner surface of the container 37 by an internal cylinder 30. The heat resisting sheet 39 may be tied to the internal cylinder 30 from outside by a rubber band, not illustrated, to constitute a container 37.

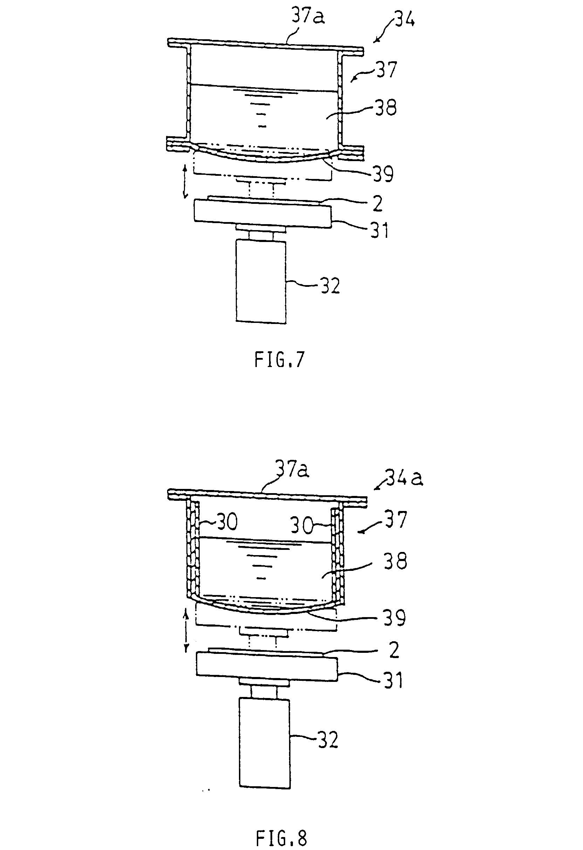

FIG. 7 shows another working example of this invention.

A belt conveyor is not used. A printed board 2 is set on the heating plate 31 situated on a cylinder 32 of a lifting means and is pressed and heated conductively by the heat resisting sheet 39 which ascends with the heating plate 31. It goes without saying that the lifting means is not limited to the cylinder 32.

FIG. 8 shows another working example of this invention.

There are common parts between the constitution and that shown in FIG. 7, but in the former the end portion of the heat resisting sheet 39 is held between the inner surface of the container 37 and the outer surface of the internal cylinder 30, which is different from that shown in FIG. 7.

The heat resisting sheet 39 may be tied to the internal cylinder 30 from outside by a rubber band, not illustrated, to constitute a container 37.

In the above-mentioned working examples, a belt conveyor for mass production and a cooling device for cooling the printed board 2 after heating it, not illustrated can be used, but they may be excluded.

This invention can be used in a soldering process in which parts and a printed board are soldered and utilized by electric equipment manufacturers or the like.

## Claims

1. A soldering equipment comprising a heating device (34) which heats a printed board (2) with soldering paste and parts on it to melt the soldering paste and further comprising a press heating device (34), **characterised** in that the press heating device (34) consists of a patchless or seamless, flexible heat resisting sheet (39), a container (37) with a downward opening closed up by the heat resisting sheet (39), heat resisting liquid (38) in the container (37), and the heating device (34) is provided for heating the heat resisting liquid (38) in the container (37), the heat resisting sheet (39) pressing and heating the parts after descending from above.

2. A soldering equipment comprising a heating device (34) which heats a printed board (2) with soldering paste and parts on it to melt the soldering paste and further comprising a press heating device (34), **characterised** in that the press heating device (34) consists of a patchless or seamless, flexible heat resisting sheet (39), a container (37) with a downward opening closed up by the heat resisting sheet (39), heat resisting liquid (38) put in the container (37) and the heating device (34) is provided for heating the heat resisting liquid (38) in the container (37), and a lifting means (32) presses the parts against the heat resisting sheet (39) by lifting the printed board (2) set on a heating plate (31).

3. The soldering equipment as claimed in claim 1 or 2, wherein a hot wind heating apparatus is provided for jetting hot air against the printed board from below which is set under the press heating device.

4. The soldering equipment as claimed in any of claims 1 to 3, wherein a conveyor (1) to convey the printed board (2) below the press heating device (34) is added.

## Patentansprüche

1. Löteinrichtung, umfassend eine Heizeinrichtung (34), die eine Leiterplatte (2) mit Lötpaste und Teilen darauf erhitzt zum Schmelzen der Lötpaste, und ferner umfassend eine Preß-Heizeinrichtung (34), dadurch **gekennzeichnet,** daß die Preß-Heizeinrichtung (34) aus einer flexiblen, hitzebeständigen dünnen Lage (39) ohne Flicken oder ohne Nähte, einem Behälter (37) mit einer Öffnung nach unten, die mit der hitzebeständigen dünnen Lage (39) abgeschlossen ist, hitzebeständiger Flüssigkeit (38) im Behälter (37) besteht, und die Heizeinrichtung (34) zum Heizen der hitzebeständigen Flüssigkeit (38) im Behälter (37) vorgesehen ist, wobei die hitzebeständige dünne Lage (39) nach Abwärtsbewegung von oben die Teile preßt und erhitzt.

2. Löteinrichtung, umfassend eine Heizeinrichtung (34), die eine Leiterplatte (2) mit Lötpaste und Teilen darauf zum Schmelzen der Lötpaste erhitzt, und ferner umfassend eine Preß-Heizeinrichtung, dadurch **gekennzeichnet,** daß die Preß-Heizeinrichtung (34) aus einer flexiblen, hitzebeständigen dünnen Lage (39) ohne Flicken oder ohne Nähte, einem Behälter (37) mit einer Öffnung nach unten, die durch die hitzebeständige dünne Lage (39) abgeschlossen ist, einer hitzebeständigen Flüssigkeit (38) im Behälter (37) besteht, und die Heizeinrichtung (34) zum Erwärmen der hitzebeständigen Flüssigkeit (38) im Behälter (37) vorgesehen ist, und ein Hebemittel (32) durch Anheben der auf einer Heizplatte (31) angeordneten Leiterplatte (2) die Teile gegen die hitzebeständige dünne Lage (39) preßt.

3. Löteinrichtung nach Anspruch 1 oder 2, bei der ein Heizluft-Heizgerät zum Anblasen der Leiterplatte mit Heißluft von unten vorgesehen ist, das unterhalb der Preß-Heizeinrichtung angeordnet ist.

4. Löteinrichtung nach einem der Ansprüche 1 bis 3, bei der eine Fördereinrichtung (1) hinzugefügt ist, um die Leiterplatte (2) unter die Preß-Heizeinrichtung (34) zu transportieren.

## Revendications

1. Appareil de brasage comprenant un dispositif de chauffage (34) qui chauffe une plaquette (2) de circuits imprimés sur laquelle sont placés une pâte de brasage et des composants et comprenant, en outre, un dispositif de chauffage et de pression (34), caractérisé en ce que le dispositif (34) de chauffage et de pression consiste en une feuille (39), formée d'une seule pièce, c'est-à-dire sans joints, flexible et résistante à la chaleur, un récipient (37) comportant une ouverture orientée vers le bas et fermée par la feuille (39) résistante à la chaleur, un liquide (38) résistant à la chaleur disposé dans le récipient (37), et le dispositif de chauffage (34) est présent pour chauffer le liquide (38) résistant à la chaleur se trouvant dans le récipient (37), la feuille (39) résistante à la chaleur pressant et chauffant les composants après avoir été abaissée depuis le dessus.

2. Appareil de brasage comprenant un dispositif de chauffage (34) qui chauffe une plaquette (2) de circuits imprimés sur laquelle sont placés une pâte de brasage et des composants de manière à faire fondre la pâte de brasage et comprenant, en outre, un dispositif de chauffage et de pression (34), caractérisé en ce que le dispositif de chauffage et de pression (34) consiste en une feuille (39), formée d'une seule pièce, c'est-à-dire sans joints, flexible et résistante à la chaleur, un récipient (37) comportant une ouverture orientée vers le bas et fermée par la feuille (39) résistante à la chaleur, un liquide (38) résistant à la chaleur disposé dans le récipient (37) et le dispositif de chauffage (34) est présent pour chauffer le liquide (38) résistant à la chaleur se trouvant dans le récipient (37), et un moyen de levage (32) presse les composants contre la feuille (39) résistante à la chaleur en soulevant la plaquette (2) de circuits imprimés placée sur la plaque de chauffage (31).

3. Appareil de brasage selon la revendication 1 ou 2, dans lequel un dispositif de chauffage à vent chaud est présent pour projeter de l'air chaud contre la plaquette de circuits imprimés depuis le dessous, ce dispositif étant placé sous le dispositif de chauffage et de pression.

4. Appareil de brasage selon l'une quelconque des revendications 1 à 3, dans lequel un convoyeur (1) est adjoint pour transporter la plaquette (2) de circuits imprimés en dessous du dispositif de chauffage et de pression (34).
